# EUROPÄISCHE PATENTSCHRIFT

(11) **EP 1 176 604 B1**
(45) Veröffentlichungstag und Bekanntmachung des Hinweises auf die Patenterteilung: **03.01.2007**
(21) Anmeldenummer: 01111474.1
(22) Anmeldetag: 10.05.2001
(51) Int. Cl.: G11C 29/00

(54) **Verfahren zum Testen einer Vielzahl von Wortleitungen einer Halbleiterspeicheranordnung**
Method for testing a plurality of word lines in a semiconductor memory device
Méthode pour tester une pluralité de lignes de mots dans un dispositif de mémoire à semiconducteurs

(30) Priorität: 26.05.2000 DE 10026275
(43) Veröffentlichungstag der Anmeldung: 30.01.2002
(73) Patentinhaber: Infineon Technologies AG, 81669 München (DE)
(72) Erfinder: Brass, Eckhard, Dr., 82008 Unterhaching (DE); Schaffroth, Thilo, 85244 Roehrmoos (DE); Schnabel, Joachim, 81549 München (DE); Schneider, Helmut, 80993 München (DE)
(74) Vertreter: Müller - Hoffmann & Partner

(56) Entgegenhaltungen:
- US-A- 5 638 331
- US-A- 5 959 890
- PATENT ABSTRACTS OF JAPAN vol. 1998, no. 07, 31. März 1998 (1998-03-31) & JP 06 309867 A (SAMSUNG ELECTRON CO LTD), 4. November 1994 (1994-11-04)

## Beschreibung

Die vorliegende Erfindung betrifft ein Verfahren zum Testen einer Vielzahl von Wortleitungen einer Halbleiterspeicheranordnung bei einem Multiple-Wortleitungs-(WL-)Wafertest, bei dem mehrere Wortleitungen zunächst auf ein hohes Potential hochgefahren und so aktiv geschaltet werden und bei dem die so hochgefahrenen aktiven Wortleitungen sodann auf ein negatives VNWL-Potential heruntergefahren werden.

Bei jüngeren Generationen von Halbleiterspeicheranordnungen, wie beispielsweise bei der 0,14 µm-SDRAM-Generation, werden inaktive Wortleitungen, also Wortleitungen die nicht zum Schreiben oder Lesen einer Speicherzelle aktiviert sind, nicht wie bisher auf Masse- bzw. Ground-Potential, also 0 V, gelegt, sondern auf eine geringfügig negative Wortleitungsspannung VNWL von etwa -0,3 V gebracht. Diese negative Wortleitungsspannung VNWL wird in der Halbleiterspeicheranordnung von einem hierfür eigenen Generator bereitgestellt.

Das Herunterfahren der inaktiven Wortleitungen auf eine leicht negative Spannung hat gegenüber dem Ground-Potential von 0 V einen wesentlichen Vorteil: Durch die negative Wortleitungsspannung VNWL wird nämlich der Sperrstrom der Auswahltransistoren der einzelnen Speicherzellen reduziert, was diese Transistoren Daten länger halten läßt. Mit anderen Worten, die negative Wortleitungsspannung führt zu einer Verbesserung der Datenrückhalte- bzw. Retentionszeit.

Werden Halbleiterspeicheranordnungen so ausgelegt, daß bei ihnen inaktive Wortleitungen auf einer geringfügig negativen Wortleitungsspannung VNWL liegen, um die Daten-Retentionszeit zu verbessern, so führt dies aber zu Problemen beim sogenannten "Multiple-WL-Wafertest", bei dem mehrere Wortleitungen zunächst auf ein hohes Potential hochgefahren und so aktiv geschaltet werden, und bei dem sodann die so hochgefahrenen aktiven Wortleitungen auf ein niedriges Potential heruntergebracht werden. Beim Multiple-WL-Wafertest werden also erheblich mehr Wortleitungen hochgefahren als im Normalbetrieb der Halbleiterspeicheranordnung.

Ein solches Testverfahren ist z. B. in dem veröffentlichten Patent US5638331 beschrieben.

Werden nun nach dem Hochfahren einer Vielzahl von Wortleitungen in den aktiven Zustand diese wieder heruntergefahren, so ziehen infolge der sehr großen Kapazität der vielen aktiven Wortleitungen diese beim Herunterfahren das Potential der VNWL-Spannung hoch, so daß dieses 0 V oder höhere Werte annehmen kann. Dadurch verschlechtert sich zwangsläufig die Retentionszeit der inaktiven, nicht an hochgefahrenen Wortleitungen liegenden Speicherzellen erheblich, so daß sogar Speicherzelleninhalte verlorengehen können.

Das oben aufgezeigte Problem tritt bei Halbleiterspeicheranordnungen, bei denen die inaktiven Wortleitungen auf Ground-Potential liegen, nicht auf, was darauf zurückzuführen ist, daß das Netz, welches das Ground-Potential bereitstellt, erheblich niederohmiger und wesentlich stärker kapazitiv gepuffert ist als das das VNWL-Potential liefernde Netz.

Zur Überwindung des oben aufgezeigten Problems wurde bisher daran gedacht, die aktiven Wortleitungen beim Multiple-WL-Wafertest nicht auf einmal, sondern langsam in zwei Stufen auf VNWL-Potential, nämlich in einem ersten Schritt auf Ground-Potential und sodann in einem zweiten Schritt auf das VNWL-Potential, herunterzufahren. Dadurch kann zwar ein Hochziehen des VNWL-Potentials der inaktiven Wortleitungen weitgehend vermieden werden.

Ein derartiges zweistufiges Herunterfahren der aktiven Wortleitungen beim Multiple-WL-Wafertest ist aber aufwendig und erfordert erheblich mehr Zeit als ein Herunterfahren in nur einer Stufe.

Es ist daher Aufgabe der vorliegenden Erfindung, ein Verfahren zum Testen einer Vielzahl von Wortleitungen einer Halbleiterspeicheranordnung bei einem Multiple-WL-Wafertest anzugeben, das es erlaubt, diesen Wafertest rasch und ohne großen Aufwand durchzuführen.

Diese Aufgabe wird bei einem Verfahren der eingangs genannten Art erfindungsgemäß dadurch gelöst, daß die nicht hochgefahrenen und damit inaktiven Wortleitungen vor dem Herunterfahren der aktiven Wortleitungen hochohmig auf dem negativen VNWL-Potential floaten und daß nach dem Herunterfahren der aktiven Wortleitungen alle Wortleitungen wieder mit dem negativen VNWL-Potential verbunden werden.

Bei dem erfindungsgemäßen Verfahren werden also die inaktiven Wortleitungen kurz vor dem Herunterfahren der aktiven Wortleitungen beim Multiple-WL-Wafertest nicht mit dem negativen VNWL-Potential verbunden. Vielmehr werden diese inaktiven Wortleitungen hochohmig auf dem negativen VNWL-Potential zum Floaten gebracht. Erst dann, wenn alle Wortleitungen heruntergefahren sind, werden auch alle Wortleitungen mit dem negativen VNWL-Potential verbunden.

Ein derartiges Vorgehen ist äußerst vorteilhaft, da die herunterfahrenden Wortleitungen die inaktiven Wortleitungen aufgrund der kapazitiven Kopplung zwischen diesen Wortleitungen nur noch weiter herunterziehen können.

Das erfindungsgemäße Verfahren ist ohne größere Änderungen in den bestehenden Halbleiterspeicheranordnungen auf einfache Weise realisierbar: es ist lediglich erforderlich, die Logik von Wortleitungstreibern, welche das VNWL-Potential liefern, entsprechend an den obigen Verfahrensablauf anzupassen oder den Generator, der das VNWL-Potential zur Verfügung stellt, stärker auszulegen, was aber zusätzliche Chipfläche erfordert.

Bei dem erfindungsgemäßen Verfahren ist also von wesentlicher Bedeutung, daß die inaktiven Wortleitungen kurz vor dem Herunterfahren der aktiven Wortleitungen beim Multiple-WL-Wafertest von der negativen Spannung abgekoppelt und hochohmig geschaltet werden.

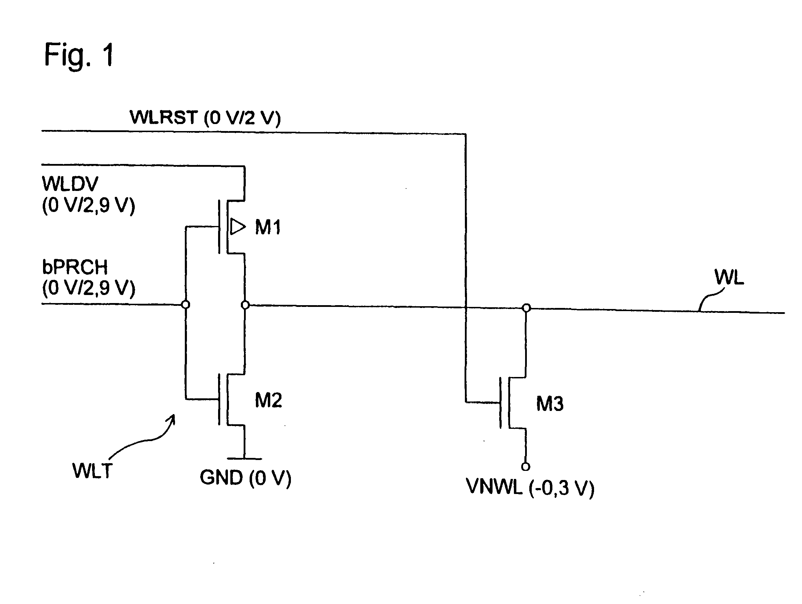

Nachfolgend wird ein Ausführungsbeispiel der Erfindung anhand der Zeichnung näher erläutert, in deren einziger Figur ein schematisches Schaltbild eines Wortleitungstreibers für die 0,14 *µ*m-SDRAM-Generation dargestellt ist.

Eine Wortleitung WL ist an einen Wortleitungstreiber WLT aus komplementären Feldeffekttransistoren M1, M2 angeschossen, welche in Reihe zwischen Ground-Potential GND und einer Wortleitung-Ansteuerspannung WLDV von 0 V bzw. 2,9 V liegen und über eine Vorladespannung bPRCH von ebenfalls 0 V bzw. 2,9 V angesteuert sind. Ein Feldeffekttransistor M3 liegt zwischen der Wortleitung WL und dem negativen VNWL-Potential von -0,3 V und ist über ein Wortleitung-Rückstellsignal WLRST von 0 V bzw. 2 V ansteuerbar.

Im Multiple-WL-Wafertest wird die Wortleitung WL über den Wortleitungstreiber WLT bei ausgeschaltetem Transistor M3 auf 2,9 V hochgefahren und sodann wieder auf 0 V heruntergefahren.

Ist die dargestellte Wortleitung WL eine inaktive Wortleitung und sind andere, nicht gezeigte Wortleitungen des Speicherzellenfeldes aktiv geschaltet, so ist die Wortleitung WL zunächst bei eingeschaltetem Feldeffekttransistor M3 auf dem VNWL-Potential von -0,3 V. Kurz vor dem Herunterfahren der aktiven Wortleitungen wird die Wortleitung WL hochohmig auf dem VNWL-Potential zum Floaten gebracht. Hierzu wird ein entsprechendes WLRST-Signal an den Transistor M3 angelegt, um diesen auszuschalten. Bei ebenfalls ausgeschaltetem Wortleitungstreiber WLT floatet dann die inaktive Wortleitung WL hochohmig auf dem VNWL-Potential von -0,3 V.

Sind alle Wortleitungen des Speicherzellenfeldes der Halbleiterspeicheranordnung heruntergefahren, so werden alle Wortleitungen WL wieder mit dem VNWL-Potential verbunden, wozu an den Transistor M3 ein entsprechendes WLRST-Signal angelegt wird.

## Patentansprüche

1. Verfahren zum Testen einer Vielzahl von Wortleitungen (WL) einer Halbleiterspeicheranordnung bei einem Multiple-WL-Wafertest, bei dem mehrere Wortleitungen (WL) zunächst auf ein hohes Potential hochgefahren und so aktiv geschaltet werden und bei dem die so hochgefahrenen aktiven Wortleitungen (WL) sodann auf ein niedriges Potential heruntergefahren werden,
**dadurch gekennzeichnet, daß**
die nicht hochgefahrenen und damit inaktiven Wortleitungen vor dem Herunterfahren der aktiven Wortleitungen (WL) hochohmig auf einem negativen Wortleitungspotential (VNWL) floaten und daß nach dem Herunterfahren der aktiven Wortleitungen alle Wortleitungen wieder mit dem negativen VNWL-Potential verbunden werden.

2. Verfahren nach Anspruch 1,
**dadurch gekennzeichnet, daß**
die inaktiven Wortleitungen vor dem Herunterfahren der aktiven Wortleitungen mit dem negativen Wortleitungspotential (VNWL) verbunden sind.

3. Verfahren nach Anspruch 1 oder 2,
**dadurch gekennzeichnet, daß**
für das Wortleitungspotential (VNWL) ein Potential von etwa -0,3 V verwendet wird.

4. Verfahren nach einem der Ansprüche 1 bis 3,
**dadurch gekennzeichnet, daß**
das negative Wortleitungspotential (VNWL) über einen Transistor (M3) an die Wortleitung (WL) gelegt wird.

## Claims

1. Method for testing a multiplicity of word lines (WL) of a semiconductor memory arrangement in a multiple WL wafer test in which a number of word lines (WL) are first ramped up to a high potential and are thus enabled, and in which the active word lines (WL) thus ramped up are then ramped down to a low potential, **characterized in that** the word lines not ramped up and thus inactive are floating at a negative word line potential (VNWL) potential with a high impedance before the active word lines (WL) are ramped down, and **in that**, after the active word lines have been ramped down, all word lines are reconnected to the negative VNWL potential.

2. Method according to Claim 1, **characterized in that** the inactive word lines are connected to the negative word line potential (VNWL) potential before the active word lines are ramped down.

3. Method according to Claim 1 or 2, **characterized in that** a potential of about -0.3 V is used for the word line potential (VNWL) potential.

4. Method according to one of Claims 1 to 3, **characterized in that** the negative word line potential (VNWL) potential is applied to the word line (WL) by a transistor (M3).

## Revendications

1. Procédé pour tester une pluralité de lignes WL de mots d'un dispositif de mémoire à semi-conducteurs, dans un test multiple -WL-wafer, dans lequel on fait fonctionner d'abord à un potentiel haut plusieurs lignes WL de mots et ainsi on les rend actives et dans lequel on fait fonctionner immédiatement ensuite les lignes WL de mots ainsi actives à un potentiel bas, **caractérisé en ce que** les lignes de mots qui ne fonctionnent pas à un potentiel haut et qui sont ainsi inactives, sont, avant que les lignes WL de mots actives fonctionnent à un potentiel bas, mises flottantes à grande valeur ohmique à un potentiel VNWL de lignes de mots négatif et **en ce que**, après que les lignes de mots actives fonctionnent à un potentiel bas, toutes les lignes de mots sont reliées à nouveau au potentiel VNWL négatif.

2. Procédé suivant la revendication 1, **caractérisé en ce que** les lignes de mots inactives sont reliées avant que les lignes de mots actives fonctionnent à un potentiel bas, au potentiel (VNWL) de lignes de mots négatif.

3. Procédé suivant les revendications 1 ou 2, **caractérisé en ce que** l'on utilise, pour le potentiel VNWL de lignes de mots, un potentiel d'environ -0,3V.

4. Procédé suivant l'une des revendications précédentes, **caractérisé en ce que** le potentiel VNWL de lignes de mots négatif est appliqué par un transistor (M3) à la ligne (WL) de mots.
